# EUROPEAN PATENT APPLICATION

(11) **EP 2 784 378 A2**
(43) Date of publication of application: **01.10.2014**
(21) Application number: 13183840.1
(22) Date of filing: 11.09.2013
(51) Int. Cl.: F21V 8/00

(54) **Solid state lighting device**

(30) Priority: 25.03.2013 JP 2013062963
(71) Applicant: Toshiba Lighting & Technology Corporation, Yokosuka-shi, Kanagawa 237-8510 (JP)
(72) Inventor: Matsuba, Yoshiaki, Kanagawa 237-8510 (JP)
(74) Representative: Bokinge, Ole

(57) **Abstract**

According to one embodiment, a solid state lighting device includes an irradiating section (10), an optical waveguide body (30), a reflecting section (50), and a first wavelength conversion layer (40). The irradiating section (10) emits laser light (70). The optical waveguide body (30) includes an incident surface into which the laser light is led (70), an inclined surface crossing an optical axis of the laser light (70), and an emission surface. The thickness between the inclined surface and the emission surface decreases as the inclined surface and the emission surface are further away from the incident surface. The reflecting section (50) is provided on the inclined surface. The first wavelength conversion layer (40) is provided on the inclined surface and configured to emit wavelength-converted light (73) having a wavelength larger than the wavelength of the laser light (70) and emit the laser light (70) as scattered light. Mixed light of the scattered light and the wavelength-converted light (73) is emitted to above the emission surface.

## Description

### FIELD

Embodiments described herein generally relate to a solid-state lighting device.

### BACKGROUND

As a light source of a white solid state lighting (SSL) device using a solid state light-emitting element, an LED (Light Emitting Diode) is mainly used.

In that case, in most cases, an LED chip is mounted on a substrate for thermal radiation and power supply and a white light-emitting section including a phosphor is provided to cover the LED chip. On the other hand, if the white light-emitting section includes only optical components, heat generation is small and the white light-emitting section is reduced in size and weight. Therefore, a degree of freedom of design of the solid state lighting device can be increased.

For that purpose, a structure only has to be adopted in which laser light from a semiconductor laser in a wavelength range of bluish purple to blue is efficiently coupled to a optical waveguide body or the like and irradiated on a wavelength conversion layer such as a phosphor separated from the solid state light-emitting element to obtain white emitted light.

A linear light source guides the laser light along a long optical waveguide body. However, if the long optical waveguide body is used for a spotlight source or a general light source, it is not easy to realize high light extracting efficiency and a reduction in size.

### BRIEF DESCRIPTION OF THE DRAWINGS

FIG. 1A is a schematic perspective view of a solid state lighting device according to a first embodiment;
FIG. 1B is a schematic sectional view taken along line A-A in FIG. 1A;
FIG. 1C is a schematic sectional view taken along line B-B in FIG. 1A;
FIG. 2A is a schematic perspective view of a solid state lighting device according to a second embodiment;
FIG. 2B is a schematic sectional view taken along line A-A in FIG. 2A;
FIG. 2C is a schematic sectional view taken along line B-B in FIG. 2A;
FIG. 3A is a schematic perspective view of a solid state lighting device according to a third embodiment;
FIG. 3B is a schematic sectional view taken along line A-A in FIG. 3A;
FIG. 3C is a schematic sectional view taken along line B-B in FIG. 3A;
FIG. 4 is a schematic sectional view of a modification of the third embodiment;
FIG. 5A is a schematic sectional view of a first modification of an optical waveguide body;
FIG. 5B is a schematic sectional view of a second modification of the optical waveguide body;
FIG. 5C is a schematic sectional view of a third modification of the optical waveguide body;
FIG. 6A is a schematic perspective view of a solid state lighting device according to a fourth embodiment;
FIG. 6B is a schematic sectional view taken along line A-A in FIG. 6A; and
FIG. 6C is a schematic sectional view taken along line B-B in FIG. 6A.

### DETAILED DESCRIPTION

In general, according to one embodiment, there is provided a solid state lighting device including an irradiating section, a optical waveguide body, a reflecting section, and a first wavelength conversion layer. The irradiating section emits laser light. The optical waveguide body has an incident surface into which the laser light is introduced, an inclined surface crossing an optical axis of the laser light, and an emission surface. The thickness between the inclined surface and the emission surface decreases as the inclined surface and the emission surface are further away from the incident surface. The reflecting section is provided on the inclined surface. The first wavelength conversion layer is provided on the emission surface and emits wavelength-converted light having a wavelength longer than the wavelength of the laser light and emit the laser light as scattered light. Mixed light of the scattered light and the wavelength-converted light is emitted to above the emission surface.

Embodiments are explained below with reference to the drawings.

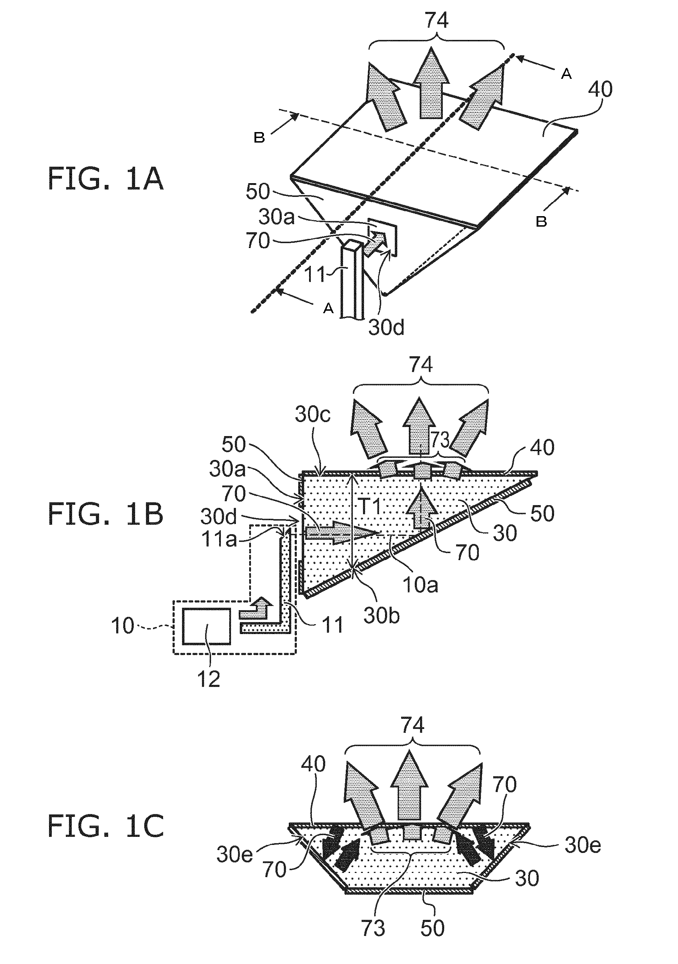

FIG. 1A is a schematic perspective view of a solid state lighting device according to a first embodiment. FIG. 1B is a schematic sectional view taken along line A-A in FIG. 1A. FIG. 1C is a schematic sectional view taken along line B-B in FIG. 1A.

The solid state lighting device includes an irradiating section 10, a optical waveguide body 30, a wavelength conversion layer 40, and reflecting sections 50.

The irradiating section 10 can include a semiconductor laser 12 configured to emit laser light 70 and an incident-light guiding section 11. The wavelength of the laser light 70 can be a wavelength of ultraviolet light (380 nm) to a wavelength of blue light (490 nm) or the like. The light guiding section 11 can be, for example, an optical fiber.

The optical waveguide body 30 has an incident surface 30a into which the laser light 70 is led, an inclined surface 30b crossing an optical axis 10a of the laser light 70, and an emission surface 30c. Thickness T1 (in a direction perpendicular to the emission surface 30c) between the inclined surface 30b and the emission surface 30c decreases as the inclined surface 30b and the emission surface 30c are further away from the incident surface 30a.

The optical waveguide body 30 can further have side surfaces 30e. The shape of the optical waveguide body 30 shown in FIGS. 1A to 1C is a pentahedron but is not limited to a polyhedron. For example, the side surfaces 30e and the inclined surface 30b may include curved surfaces. If a reflection preventing film is provided in a lead-in region 30d for the laser light 70 on the incident surface 30a, it is possible to improve incident efficiency of the laser light 70.

The optical waveguide body 30 has translucency and can be transparent ceramics, glass, quartz, transparent resin, or the like. For example, transparent ceramics made of YAG (Yttrium Aluminum Garnet) has, for example, a refractive index of about 1.83 and heat conductivity of about 11.7 W/(m·K). The transparent ceramics has high translucency in the wavelengths of ultraviolet light to the wavelength of visible light. That is, the optical waveguide body 30 is a material that transmits at least visible light and preferably has light transmittance equal to or higher than 60%.

The reflecting sections 50 are provided on the inclined surface 30b and the side surface 30e of the optical waveguide body 30. If the reflecting section 50 is also provided in a region excluding the lead-in region 30d for the laser light 70 on the incident surface 30a of the optical waveguide body 30, the laser light 70 is suppressed from being emitted to the outside. Therefore, it is possible to improve safety of the solid state lighting device.

The reflecting sections 50 can be, for example, metal having high light-reflectance to ultraviolet light to blue light such as Ag or Al or a dielectric multilayer film including two films having different dielectric constants. If the structure of the dielectric multilayer film is a Bragg reflector or the like, light-reflectance equal to or higher than 90% can be obtained at a desired wavelength.

In the first embodiment, the wavelength conversion layer 40 is provided on the emission surface 30c of the optical waveguide body 30. The wavelength conversion layer 40 can be a yellow phosphor (Y), a red phosphor (R), a green phosphor (G), and the like.

A full width at half maximum (FWHM) representing the spread angle of laser light is, for example, about 40 degrees in the vertical direction (θv) and about 15 degrees in the horizontal direction (θh) and is smaller than the spread angle of an LED (Light Emitting Diode). Therefore, it is possible to improve incident efficiency on an optical fiber or the like.

The laser light 70 emitted from an oblique cut surface 11a of the incident-light guiding section 11 of the optical fiber or the like is led into the optical waveguide body 30, irradiated on the inclined surface 30b (FIG. 1B) and the side surfaces 30e (FIG. 1C) while spreading on the inside of the optical waveguide body 30, reflected on the reflecting sections 50, and made incident on the wavelength conversion layer 40 while further spreading.

The laser light 70 made incident on the wavelength conversion layer 40 is partly absorbed by the wavelength conversion layer 40 while being scattered and is emitted as wavelength-converted light 73. Another part of the laser light 70 is converted into scattered light in the wavelength conversion layer 40 and emitted. The scattered light and the wavelength-converted light 73 change to mixed light 74 and illumination light. For example, the yellow phosphor on which blue laser light is irradiated emits yellow light. The yellow light is mixed with blue scattered light scattered and generated by the yellow phosphor and is emitted as white light or the like.

As the wavelength conversion layer 40, a single phosphor selected out of a nitride phosphor such as (Ca,Sr)₂Si₅N₈:Eu or (Ca,Sr)AlSiN₃:Eu, an oxynitride phosphor such as Cax(Si,Al)₁₂(O,N)₁₆:Eu, (Si,Al)₆(O,N)₈:Eu, BaSi₂O₂N₂:Eu, or BaSi₂O₂N₂:Eu, an oxide phosphor such as Lu₃Al₅O₁₂:Ce, (Y,Gd)₃(Al,Ga)₅O₁₂:Ce, (Sr,Ba)₂SiO₄:Eu, Ca₃Sc₂Si₃O₁₂:Ce, or Sr₄Al₁₄O₂₅:Eu, and a sulfide phosphor such as (Ca,Sr)S:Eu, CaGa₂S₄:Eu, ZnS:Cu, Al or a phosphor obtained by mixing at least one or more kinds of the phosphors can be used.

In the first embodiment, the laser light 70 is efficiently introduced into the incident surface 30a of the optical waveguide body 30. The laser light 70 led into the incident surface 30a is reflected on the reflecting section 50 provided on the inclined surface 30b and can be efficiently made incident on the wavelength conversion layer 40. Therefore, it is possible to improve light extracting efficiency while keeping the size of the optical waveguide body 30 small.

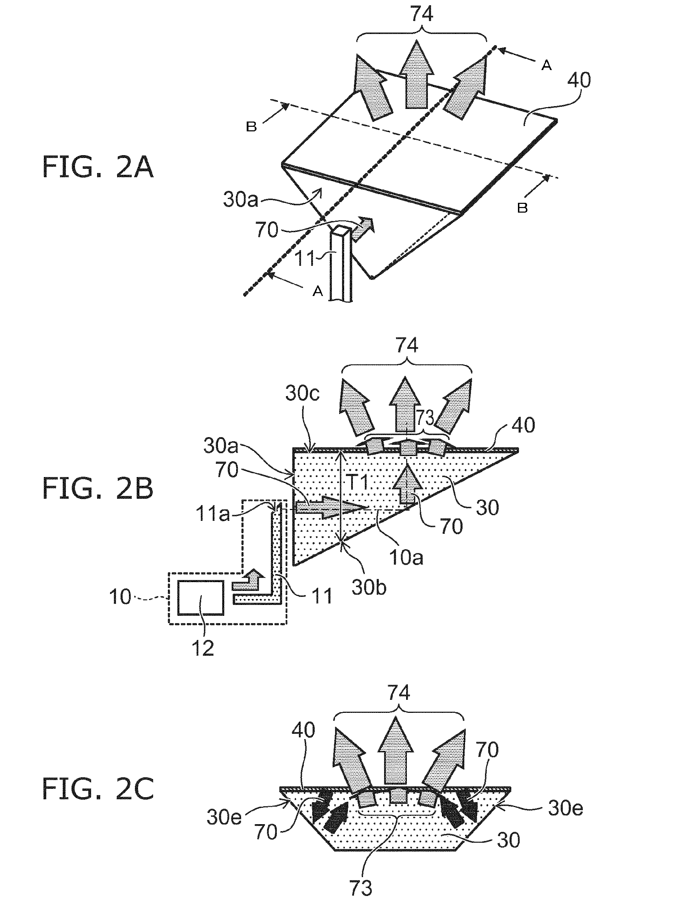

FIG. 2A is a schematic perspective view of a solid state lighting device according to a second embodiment. FIG. 2B is a schematic sectional view taken along line A-A in FIG. 2A. FIG. 2C is a schematic sectional view taken along line B-B in FIG. 2A.

In the laser light 70 made incident on the inclined surface 30b of the optical waveguide body 30, light having an incident angle equal to or larger than a critical angle is totally reflected on the inclined surface 30b and reaches the wavelength conversion layer 40. That is, the inclined surface 30b itself can configure a reflecting section.

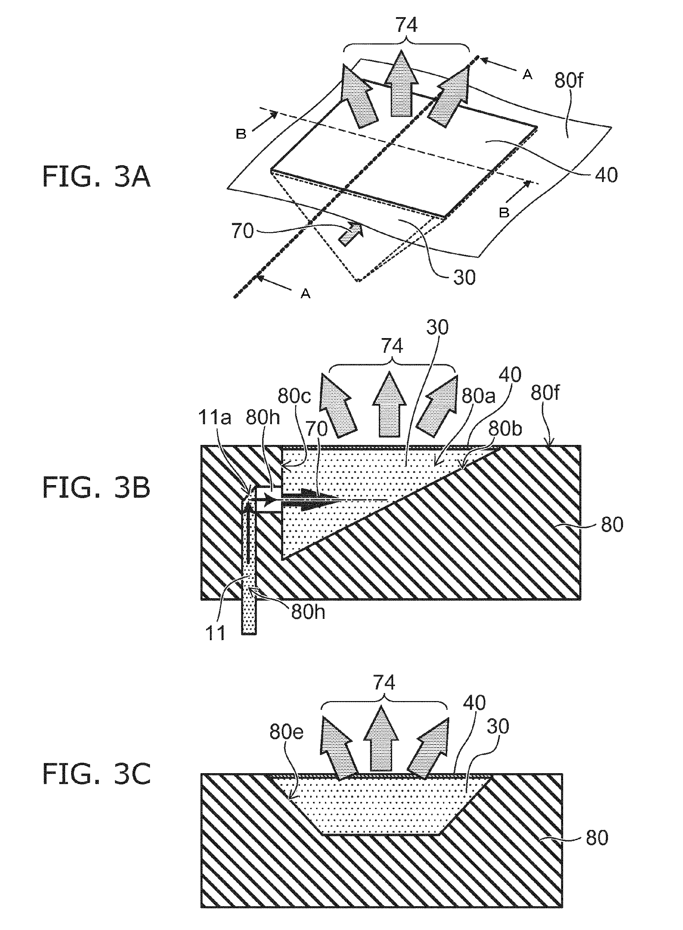

FIG. 3A is a schematic perspective view of a solid state lighting device according to a third embodiment. FIG. 3B is a schematic sectional view taken along line A-A in FIG. 3A. FIG. 3C is a schematic sectional view taken along line B-B in FIG. 3A.

The solid state lighting device includes an irradiating section including the incident-light guiding section 11, the optical waveguide body 30, the wavelength conversion layer 40, and a base section 80.

In the base section 80, a recess 80a receding from an upper surface 80f of the base section 80 is provided. The recess 80a has an inclined surface 80b, an inner wall 80c, and side surfaces 80e. Further, in the base section 80, a hollow section 80h, in which the incident-light guiding section 11 is interposed, is provided. The distal end portion of the incident-light guiding section 11 interposed in the hollow section 80h emits the laser light 70 to the incident surface 30a of the optical waveguide body 30.

In FIG. 3B, the incident-light guiding section 11 is an optical fiber. The distal end portion of the incident-light guiding section 11 is the oblique cut surface 11a. The laser light 70 is totally reflected on the oblique cut surface 11a and emitted. When the optical fiber is used, the shape of the hollow section 80h of the base section 80 is not limited to the shape shown in FIG. 3B. For example, the hollow section 80h can be set substantially parallel to an upper surface 80f of the base section 80. Then, the laser light 70 can be directly emitted without being reflected on the end face of the optical fiber.

When the power of the laser light 70 increases, an amount of heat in the wavelength conversion layer 40 increases. If the base section 80 is made of metal such as Al, Cu, Ti, Si, Ag, Au, Ni, Mo, W, Fe, or Nb, thermal radiation is improved. Therefore, it is possible to improve light emission efficiency and reliability.

If the surface of the inclined surface 80b of the base section 80 is formed as a metal layer having high light-reflectance, the surface acts as a reflecting section.

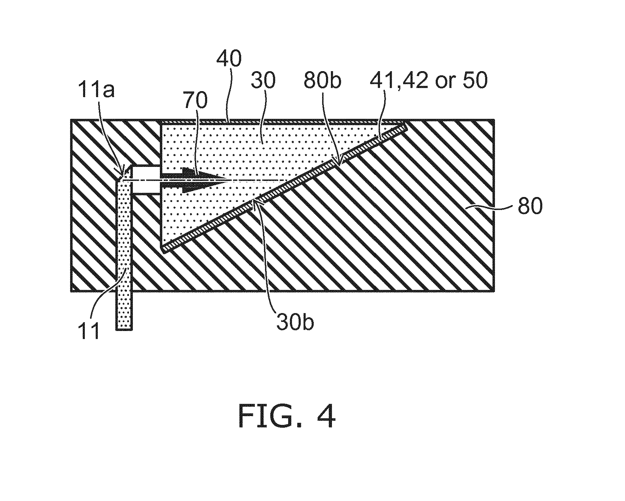

FIG. 4 is a schematic sectional view of a modification of the third embodiment.

The reflecting section 50 can be provided between the inclined surface 30b of the optical waveguide body 30 and the inclined surface 80b of the base section 80. In this case, when a fine concave-convex surface is provided on the inclined surface 30b of the optical waveguide body 30, reflected light can be further scattered to have low coherency.

A second wavelength conversion layer 41 can be further provided between the inclined surface 30b of the optical waveguide body 30 and the inclined surface 80b of the base section 80. When the second wavelength conversion layer 41 is provided on the inclined surface 80b of the base section 80, it is possible to facilitate radiation of heat generated in the second wavelength conversion layer 41 and improve conversion efficiency of the second wavelength conversion layer 41. The wavelength of second wavelength-converted light emitted from the second wavelength conversion layer 41 is longer than the wavelength of first wavelength-converted light emitted from the first wavelength conversion layer 40. Consequently, the second wavelength-converted light is suppressed from being absorbed in the first wavelength conversion layer 40.

A light scattering layer 42 can be further provided between the inclined surface 30b of the optical waveguide body 30 and the inclined surface 80b of the base section 80. The light scattering layer 42 contains a light scattering material that reflects the laser light 70 made incident thereon and emits the laser light 70 as scattered light. The light scattering layer 42 includes particulates (particle diameter: 1 to 20 µm, etc.) of Al₂O₃, Ca₂P₂O₇, BaSO₄, or the like. The light scattering layer 42 may be a light scattering layer in which the particulates are distributed on a ceramic plate. The laser light 70 can be changed to light having lower coherency by the light scattering layer 42. Therefore, safety is further improved.

A fine concave-convex surface may be provided on the surface of the inclined surface 80b of the base section 80. In this case, a part of the laser light 70 passed through the reflecting section 50, the second wavelength conversion layer 41, or the light scattering layer 42 is scattered on the fine concave-convex surface of the inclined surface 80b and can be changed to light having lower coherency. Therefore, safety is improved.

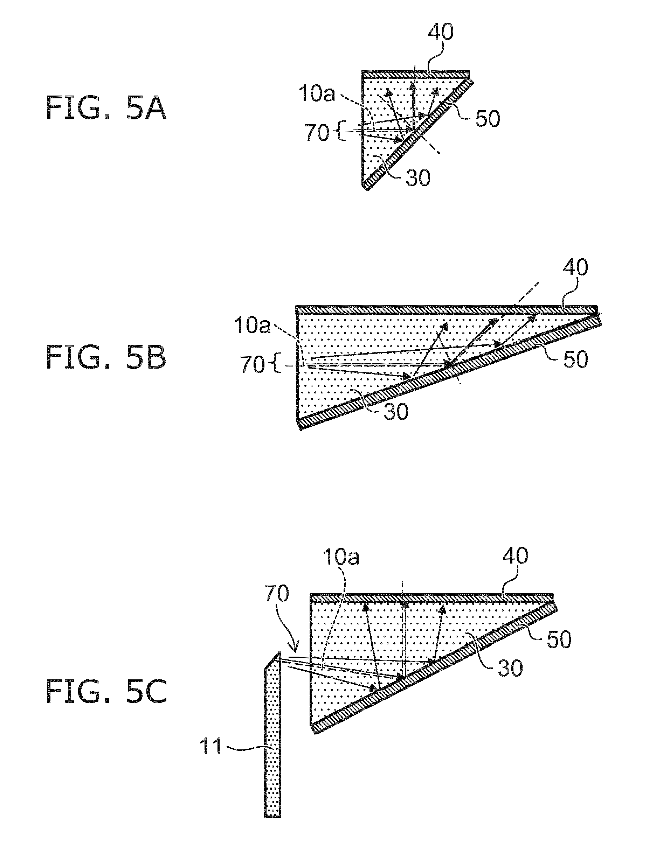

FIG. 5A is a schematic sectional view of a first modification of a optical waveguide body. FIG. 5B is a schematic sectional view of a second modification of the optical waveguide body. FIG. 5C is a schematic sectional view of a third modification of the optical waveguide body.

As shown in FIG. 5A, when the optical axis 10a of the incident laser light 70 is substantially parallel to the emission surface 30c of the optical waveguide body 30 and crosses the inclined surface 30b of the optical waveguide body 30 at about 45 degrees, the optical axis 10a of the reflected laser light 70 is substantially orthogonal to the emission surface 30c.

As shown in FIG. 5B, when the optical axis 10a of the incident laser light 70 is substantially parallel to the emission surface 30c of the optical waveguide body 30 and crosses the inclined surface 30b of the optical waveguide body 30 at an angle larger than 45 degrees, the optical axis 10a of the reflected laser light 70 obliquely crosses the emission surface 30c and the reflected light spreads in a traveling direction.

FIG. 5C shows a structure in which the optical axis 10a of the incident laser light 70 is directed downward and the optical axis of the reflected light is made orthogonal to the emission surface 30c. That is, the direction of the optical axis 10a of the laser light 70 made incident on the optical waveguide body 30 and the tilt of the inclined surface 30b can be properly set according to directional characteristics required of illumination light.

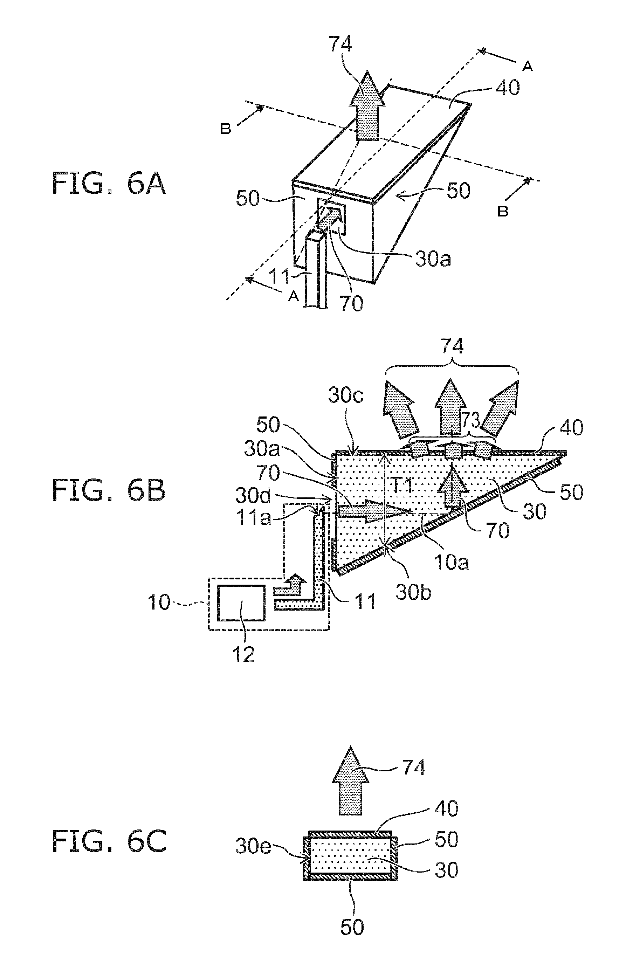

FIG. 6A is a schematic perspective view of a solid state lighting device according to a fourth embodiment. FIG. 6B is a schematic sectional view taken along line A-A in FIG. 6A. FIG. 6C is a schematic sectional view taken along line B-B in FIG. 6A.

When a horizontal direction spread angle θh of the semiconductor laser 12 is as small as about 10 degrees, even if the laser light 70 spreads in the horizontal direction, an amount of light irradiated on the side surfaces 30e is small. Therefore, the incident surface 30a is formed in a rectangular shape having small width. As a result, the optical waveguide body 30 can be reduced in size.

According to the first to fourth embodiments, it is possible to obtain the solid state lighting devices that are improved in light extracting efficiency and easily reduced in size. The solid state lighting devices can be widely used for general lighting, spot lighting, a traffic light, vehicle-mounted lighting, and the like.

In the examples explained in the first to fourth embodiments, the reflecting sections 50 have the same configuration. However, for example, the reflecting sections 50 may have different configurations on the inclined surface 30b and the side surfaces 30e of the optical waveguide body 30. For example, on the inclined surface 30b on which the laser light 70 is mainly irradiated, a reflecting layer or a total reflection surface made of Ag, Al, or the like having high light-reflectance can be formed as a first reflecting section. On the side surfaces 30e, second reflecting sections having a diffusing function made of Al₂O₃, Ca₂P₂O₇, BaSO₄, or the like can be formed. Consequently, it is possible to efficiently guide, with the first reflecting section, the laser light 70 to the wavelength conversion layer 40 and further scatter, with the second reflecting sections, a part of the laser light 70, light reflected by the wavelength conversion layer 40, and the like to have low coherency.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modification as would fall within the scope and spirit of the inventions.

## Claims

1. A solid state lighting device comprising:
an irradiating section (10) configured to emit laser light (70);
an optical waveguide body (30) including an incident surface into which the laser light is introduced, an inclined surface crossing an optical axis of the laser light (70), and an emission surface, thickness between the inclined surface and the emission surface decreasing as the inclined surface and the emission surface are further away from the incident surface;
a reflecting section (50) provided on the inclined surface; and
a first wavelength conversion layer (40) provided on the emission surface and configured to emit wavelength-converted light (73) having a wavelength longer than a wavelength of the laser light (70) and emit the laser light (70) as scattered light,
mixed light of the scattered light and the wavelength-converted light (73) being emitted to above the emission surface.

2. The device according to claim 1, wherein the reflecting section (50) is a dielectric multilayer film or a metal layer.

3. The device according to claim 1 or 2, further comprising a scattering layer (42) provided between the inclined surface and the reflecting section (50) and including a light scattering material that reflects the laser light (70) made incident thereon and emits the laser light (70) as scattered light.

4. The device according to claim 1 or 2, further comprising a second wavelength conversion layer (41) provided between the inclined surface and the reflecting section and configured to emit the wavelength-converted light (73) having a wavelength larger than the wavelength of the laser light (70) toward the emission surface and reflect the laser light (70) and emit the laser light (70) toward the emission surface as scattered light.

5. The device according to claim 1, wherein the reflecting section (50) is the inclined surface of the optical waveguide body (30) that totally reflects the laser light (70).

6. The device according to any one of claims 1 to 5, wherein the incident surface includes a light introducing region in which an antireflection film is provided.

7. The device according to any one of claims 1 to 6, wherein the optical waveguide body (30) includes one of translucent ceramics, glass, quartz, and translucent resin.

8. The device according to any one of claims 1 to 7, further comprising a base section (80) including an upper surface and provided with a recess receding from the upper surface, the optical waveguide body (30) being fit in the recess, and a hollow section through which the laser light (70) is propagated toward the incident surface.
